(19) Europäisches Patentamt
European Patent Office
Office européen des brevets

(11) EP 3 572 482 A1

(12) EUROPEAN PATENT APPLICATION
published in accordance with Art. 153(4) EPC

(43) Date of publication:
27.11.2019 Bulletin 2019/48

(51) Int Cl.:
C09K 11/88 (2006.01)        C09K 11/08 (2006.01)
H01L 33/50 (2010.01)

(21) Application number: 18741280.4

(22) Date of filing: 15.01.2018

(86) International application number:
PCT/JP2018/000807

(87) International publication number:
WO 2018/135434 (26.07.2018 Gazette 2018/30)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD TN

(30) Priority: 18.01.2017  JP 2017006353
26.12.2017  JP 2017248935

(71) Applicant: Mitsubishi Materials Corporation
Chiyoda-ku
Tokyo 100-8117 (JP)

(72) Inventors:
• OMATA, Takahisa
Sendai-shi
Miyagi 980-8577 (JP)
• UNO, Takahiro
Iwaki-shi
Fukushima 971-8101 (JP)

(74) Representative: Gille Hrabal
Brucknerstrasse 20
40593 Düsseldorf (DE)

(54) CD-FREE COLLOIDAL QUANTUM DOT CAPABLE OF EMITTING VISIBLE FLUORESCENCE, AND METHOD FOR PRODUCING SAME

(57) A Cd-free colloidal quantum dot which is a core particle that is coated with a shell made from a compound semiconductor and serves as a core for the shell, and emits visible fluorescence upon irradiation with excited light having a wavelength of a near ultraviolet region or a blue region. The colloidal quantum dot is represented by a chemical formula: $A(B1_{1-x}, B2_x)$ (wherein $0<x<1$), has Zn as a Group-II element in the A site, Te as a Group-VI element in the B1 site, and Se or S as a Group-VI element in the B2 site, and has an average particle diameter of 1 nm or more and 10 nm or less.

[FIG. 1]

FIG.1

EP 3 572 482 A1

## Description

Technical Field

The present invention relates to a colloidal quantum dot capable of emitting visible fluorescence as a type of photoluminescent material and a method for producing the same. Specifically, the present invention relates to a Cd-free colloidal quantum dot capable of emitting visible fluorescence having the same emission wavelength controllability (particle diameter controllability), and full width at half maximum (FWHM) and stokes shift of an emission spectrum as those of a CdSe-based colloidal quantum dot, and a method for producing the same. In particular, the present invention relates to a Cd-free colloidal quantum dot capable of emitting the same green or red visible fluorescence as that of a CdSe-based colloidal quantum dot, and a method for producing the same. This international application claims priority from Japanese Patent Application No. 6353 (Japanese Patent Application No. 2017-6353) filed on January 18, 2017 and from Japanese Patent Application No. 248935 (Japanese Patent Application No. 2017-248935) filed on December 26, 2017, the entire contents of which are incorporated herein.

Background Art

In recent years, higher definition and wider color gamut of pixels are highly required for liquid crystal displays (LCDs). In order to achieve a wider color gamut, it is necessary that the color purity of each of red (R), green (G), and blue (B) used in a backlight be enhanced to achieve a good chromaticity. A blue LED used for excited light has a sharp emission spectrum and high color purity, and can be set to a good chromaticity. However, there is no material which is a bulk phosphor which is excited by blue LED light and emits green or red light, has excellent conversion efficiency and high color purity, and can be set to a good chromaticity. Therefore, it is difficult to extend the color gamut in green and red regions. Currently, a countermeasure in which light having a required wavelength is extracted from emission of a phosphor with an optical filter to enhance the color purity and achieve a good chromaticity is performed, but the light transmittance is reduced due to the optical filter. Therefore, the excitation energy needs to be increased. This results in significant reduction in efficiency. Accordingly, a method for achieving a wider color gamut at high energy conversion efficiency without an optical filter is required.

In one solution of this problem, a material having a sharp emission spectrum and capable of easily controlling the emission wavelength according to control of particle diameter using a quantum size effect, such as a colloidal quantum dot, is used. Thus, a desired chromaticity can be achieved. There is an example in which a product using a blue LED and a colloidal quantum dot phosphor which is excited by the blue LED to emit light in a backlight is marketed in some LCDs.

Conventionally, CdSe/ZnS is used as a colloidal quantum dot material. However, the toxicity thereof is a problem. Therefore, a Cd-free colloidal quantum dot material is widely studied and developed. In recent years, the study and development are especially activated. For example, Non-Patent Documents 1 and 2 disclose a Cd-free colloidal quantum dot emitting green or red light.

Non-Patent Document 1 reports that a stable and highly luminous InP/ZnS core-shell colloidal quantum dot is developed by stepwise addition of zinc acetate and dodecanethiol to an InP core solution and zinc acetate plays an important role in surface etching and formation of a ZnS shell. Non-Patent Document 2 reports the origin of size-dependent photoluminescence (PL) of $CuInS_2$-ZnS alloy/ZnS core-shell colloidal quantum dot (three-element-compound semiconductor) and the effect of a ZnS thin layer coating on PL properties.

Prior Art Documents

Non-Patent Documents

Non-Patent Document 1: Ryu et al., Chem. Mater. Vol. 21 No. 4 (2009)
Non-Patent Document 2 : Nose et al., J. Phys.: Conf. Ser. 165 012028 (2009)
Non-Patent Document 3: Kamata et al., J. Crystal Growth 170 (1997)
Non-Patent Document 4 : Nanda et al., J. Appl. Phys. Vol. 95 No. 9 (2004)
Non-Patent Document 5: Pellegrini et al., J. Appl. Phys. 97 073706 (2005)

Summary of the Invention

Problems to be Solved by the Invention

The InP-based colloidal quantum dot described in Non-Patent Document 1 has the following problems. Firstly, a colloidal quantum dot having a good chromaticity is not obtained as long as the particle diameter cannot be precisely controlled. This is because the emission wavelength largely changes depending on a slight difference in particle diameter in a region of shorter wavelength than that of green light. Secondary, the energy loss is large since the InP-based colloidal quantum dot has a large stokes shift. Thirdly, a phosphide which is a synthetic raw material has very high reactivity and is dangerous.

The colloidal quantum dot of the three-element-compound semiconductor typified by $CuInS_2$ as described in Non-Patent Document 2 has the following problems. Firstly, a solid solution range where a plurality of compounds are present is wide, the difficulty of technique of synthesizing a compound in accordance with a chemical composition is very high, and recombination of electrons and holes occurs through a defect level. Secondary, the emission spectrum is broad and the color purity is deteriorated. Thirdly, the colloidal quantum dot has a large stokes shift, the energy loss is large, and it is difficult to achieve green emission.

An object of the present invention is to provide a Cd-free colloidal quantum dot capable of emitting visible fluorescence having the same emission wavelength controllability (particle diameter controllability), and full width at half maximum (FWHM) and stokes shift of emission spectrum as those of a CdSe-based colloidal quantum dot, and a method for producing the same, which solve the aforementioned problems. In particular, an object of the present invention is to provide a Cd-free colloidal quantum dot capable of emitting the same green or red visible fluorescence as that of a CdSe-based colloidal quantum dot, and a method for producing the same.

Means to Solve the Problems

The inventors of the present invention have focused on ZnS, ZnSe, and ZnTe as Cd-free II-VI compound semiconductors. The band gaps of bulk bodies of ZnS, ZnSe, and ZnTe are 3.83 eV, 2.72 eV, and 2.25 eV, respectively (which are all a sphalerite type crystal) . Colloidal quantum dots of ZnS and ZnSe cannot achieve a band gap capable of emitting light in a green region or a red region. On the other hand, a colloidal quantum dot of ZnTe is capable of emitting light in a blue-green region using a quantum size effect. However, even when the particle diameter is largely changed in the green region, a change in emission wavelength is kept small, and the controllability of emission wavelength in the green region is deteriorated.

Examples of a method for controlling a band gap include formation of mixed crystal of compounds. In a bulk crystal, occurrence of band gap bowing in which the band gap is negatively curved depending on a composition by formation of mixed crystal of compounds is known. In particular, when a mixed crystal is formed from anions like Zn(Te, S), Zn(Te, Se), and Zn(Te, O), large band gap bowing occurs, and the band gap is smaller than a band gap of a single compound which is not a mixed crystal. For example, Non-Patent Document 3 reports that in a $Zn(Te_{1-x}, Se_x)$ film formed on a GaAs substrate by MOCVD, band gap bowing is confirmed and a band gap with a molar composition ratio $x_{Se}$ of Se of 0.35 is decreased to up to 2.03 eV. The inventors have considered that such band gap bowing is achieved also in a colloidal quantum dot, and a band gap in a green region or a red region can be controlled by combination of a quantum size effect with band gap bowing. Thus, the present invention has been accomplished.

A first aspect of the present invention is a Cd-free colloidal quantum dot which is a core particle that is coated with a shell made from a compound semiconductor and serves as a core for the shell, and which emits visible fluorescence upon irradiation with excited light having a wavelength of a near ultraviolet region or a blue region. The colloidal quantum dot is represented by a chemical formula: $A(B1_{1-x1}, B2_x)$ (wherein $0<x<1$), has Zn as a Group-II element in the A site, Te as a Group-VI element in the B1 site, and Se or S as a Group-VI element in the B2 site, and has an average particle diameter of 1 nm or more and 10 nm or less.

A second aspect of the present invention is the Cd-free colloidal quantum dot according to the first aspect, wherein the B2 site is Se and the visible fluorescence is green light.

A third aspect of the present invention is the Cd-free colloidal quantum dot according to the first aspect, wherein the B2 site is S and the visible fluorescence is red light.

A fourth aspect of the present invention is a method for producing a Cd-free colloidal quantum dot capable of emitting green light as visible fluorescence, including heating any one of a first mixed liquid prepared by mixing a Zn source liquid, a Te source liquid, and a Se source liquid, and a second mixed liquid prepared by mixing a capping agent with a diluent to a temperature of 200°C to 350°C, injecting into the heated liquid a predetermined amount of the other liquid under a nonoxidative atmosphere, adjusting the temperature of the liquid obtained by injecting the other liquid into the heated liquid to 200°C to 350°C, and holding the liquid for one minute to five hours.

A fifth aspect of the present invention is a method for producing a Cd-free colloidal quantum dot capable of emitting red light as visible fluorescence, including heating any one of a third mixed liquid prepared by mixing a Zn source liquid with a Te source liquid, and a fourth mixed liquid prepared by mixing a S source liquid, a capping agent, and a diluent to a temperature of 200°C to 350°C, injecting into the heated liquid a predetermined amount of the other liquid under a nonoxidative atmosphere, adjusting the temperature of the liquid obtained by injecting the other liquid into the heated liquid to 200°C to 350°C, and holding the liquid for one minute to five hours.

Effects of the Invention

When the Cd-free colloidal quantum dot capable of emitting visible fluorescence according to the first aspect of the present invention is irradiated with excited light having a wavelength of a near ultraviolet region or a blue region, properties of the Cd-free colloidal quantum dot are more excellent than properties of the InP-based colloidal quantum dot described in Non-Patent Document 1 and properties of the colloidal quantum dot of the three-element-compound semiconductor described in Non-Patent Document 2, and the same properties as those of a CdSe-based colloidal quantum dot can be obtained. Specifically, an influence of difference in particle diameter especially in a short wavelength region on a change of emission wavelength is reduced, and the emission wavelength can be precisely controlled to achieve a good chromaticity. Further, the full width at half maximum (FWHM) of emission spectrum is reduced to improve the color purity. The stokes shift is reduced to decrease the energy loss. The properties in all terms of the Cd-free colloidal quantum dot are improved to the same level of the CdSe-based colloidal quantum dot.

In the Cd-free colloidal quantum dot capable of emitting visible fluorescence according to the second aspect of the present invention, the B2 site is Se. In this case, the Cd-free colloidal quantum dot is a $Zn(Te_{1-x}, Se_x)$ colloidal quantum dot, and thus the visible fluorescence may be green light.

In the Cd-free colloidal quantum dot capable of emitting visible fluorescence according to the third aspect of the present invention, the B2 site is S. In this case, the Cd-free colloidal quantum dot is a $Zn(Te_{1-x}, S_x)$ colloidal quantum dot, and thus the visible fluorescence may be red light.

In the method according to the fourth aspect of the present invention, the first mixed liquid prepared by mixing the Zn, Te, and Se source liquids is mixed with the second mixed liquid prepared by mixing the capping agent with the diluent and all the elements (Zn, Te, and Se) are collectively prepared. Therefore, the molar composition ratio of the colloidal quantum dot can be simply controlled as a molar preparation ratio. A liquid of lower temperature is injected into a liquid of higher temperature. Therefore, the temperature after injection can be largely changed (decreased), a colloidal quantum dot having improved separation of nucleation and nucleus growth and high uniformity is obtained. Further, a grown nuclear is held at certain temperature. Therefore, the particle diameter can be easily controlled over time. As a result, a Cd-free colloidal quantum dot capable of emitting green light as visible fluorescence is obtained.

In the method according to the fifth aspect of the present invention, the third mixed liquid prepared by mixing the Zn and Te source liquids and the fourth mixed liquid prepared by mixing the S source liquid, the capping agent, and the diluent are used. A liquid of lower temperature is injected into a liquid of higher temperature. Therefore, the temperature after injection can be largely changed (decreased), a colloidal quantum dot having improved separation of nucleation and nucleus growth and high uniformity is obtained. Further, the grown nuclear is held at certain temperature. Therefore, the particle diameter can be easily controlled over time. As a result, a Cd-free colloidal quantum dot capable of emitting red light as visible fluorescence is obtained.

Brief Description of Drawings

FIG. 1 is a view illustrating a simulation result of a band gap to a molar composition ratio $x_{Se}$ of Se in a $Zn(Te_{1-x}, Se_x)$ colloidal quantum dot having a particle diameter of 2 to 10 nm.
FIG. 2 is a view illustrating a simulation result of a band gap to the particle diameter in a $Zn(Te_{1-x}, Se_x)$ colloidal quantum dot having a molar composition ratio $x_{Se}$ of Se of 0.35.
FIG. 3 is a view illustrating a simulation result of a band gap to a molar composition ratio $x_S$ of S in a $Zn(Te_{1-x}, S_x)$ colloidal quantum dot having a particle diameter of 2 to 10 nm.
FIG. 4 is a view illustrating a simulation result of a band gap to the particle diameter in a $Zn(Te_{1-x}, S_x)$ colloidal quantum dot having a molar composition ratio $x_S$ of S of 0.35.

Embodiments of the Invention

Hereinafter, embodiments for carrying out the present invention will be described.

[Design of Material using Effective Mass Approximation Calculation]

Non-Patent Documents 4 and 5 report calculations that theoretically predict particle diameter-dependence of optical gap of a colloidal quantum dot. Among these, effective mass approximation capable of obtaining the same result as a result obtained by another procedure in accordance with a simple notation is convenient. The Schrodinger equation of a particle (mass: m) in a potential: V(r) is represented by Expression (1).
[Expression 1]

$$[(-\hbar^2/2m)\nabla^2 + V(r)]\psi(r) = E\psi(r) \qquad (1)$$

Herein, a relational expression of a particle diameter and an optical gap is derived from a model that assumes effective mass approximation in a square-well potential of finite depth. A confining potential is represented as a central-symmetric V(r) of finite depth by the following Expression (2). Herein, $r_0$ is the radius of a spherical colloidal quantum dot.
[Expression 2]

$$(a) \quad r < r_0: \quad V(r) = 0$$

$$(b) \quad r > r_0: \quad V(r) = V_0 \qquad (2)$$

$V_0$ is defined by the following Expression (3).
[Expression 3]

$$V_0 = (1/2)(\Delta E_{HOMO-LUMO} - E_g) \qquad (3)$$

Herein, $\Delta E_{HOMO-LUMO}$ is an energy difference between the highest occupied molecular orbital (HOMO) and the lowest unoccupied molecular orbital (LUMO) of a surfactant coordinated as a capping agent on a surface layer of the colloidal quantum dot. $\Delta E_{HOMO-LUMO}$ of oleic acid used as the surfactant is 4.35 eV which is a value determined by measurement of optical absorption spectrum. Additionally, for band gaps $E_g$s of bulk bodies of ZnTe, ZnSe, and ZnS and effective masses $m_e^*/m_0$ and $m_h^*/m_0$ of electrons and holes, values shown in Table 1 below are used.

TABLE 1

| | $E_g$ [eV] | $m_e^*/m_0$ | $m_h^*/m_0$ | $V_0$ [eV] |
|---|---|---|---|---|
| ZnTe | 2.25 | 0.09 | 0.60 | (4.35-$E_g$)/2 |
| ZnSe | 2.72 | 0.16 | 0.75 | (4.35-$E_g$)/2 |
| ZnS | 3.83 | 0.39 | 1.76 | (4.35-$E_g$)/2 |

As described above, a band gap E when the particle diameter of the colloidal quantum dot is $r_0$ is determined from the band gaps $E_g$s of bulk bodies of ZnTe, ZnSe, and ZnS and the effective masses $m_e^*/m_0$ and $m_h^*/m_0$ of electrons and holes.
A band gap in a bulk body of a mixed crystal system is calculated by the following Expressions (4) and (5) represented using a bowing parameter (b).
[Expression 4]

$$Eg\_Zn(Te_{1-x}, Se_x) = xEg\_ZnSe + (1-x)Eg\_ZnTe - bx(1-x) \quad (b=1.450)$$

$$(4)$$

$$Eg\_Zn(Te_{1-x}, S_x) = xEg\_ZnS + (1-x)Eg\_ZnTe - bx(1-x) \quad (b=3.83) \quad (5)$$

Herein, a relationship of the band gap, particle diameter, and molar composition ratio of the colloidal quantum dot is determined by assuming the additivity of the effective masses $m_e*/m_0$ and $m_h*/m_0$ of electrons and holes. For example, the additivity of effective mass of electrons of $Zn(Te_{1-x}, Se_x)$ is represented by the following Expression (6).
[Expression 5]

$$m_e*\_Zn(Te_{i-x}, Se_x) = xm_e*\_ZnSe + (1-x)\ m_e*\_ZnTe \quad (6)$$

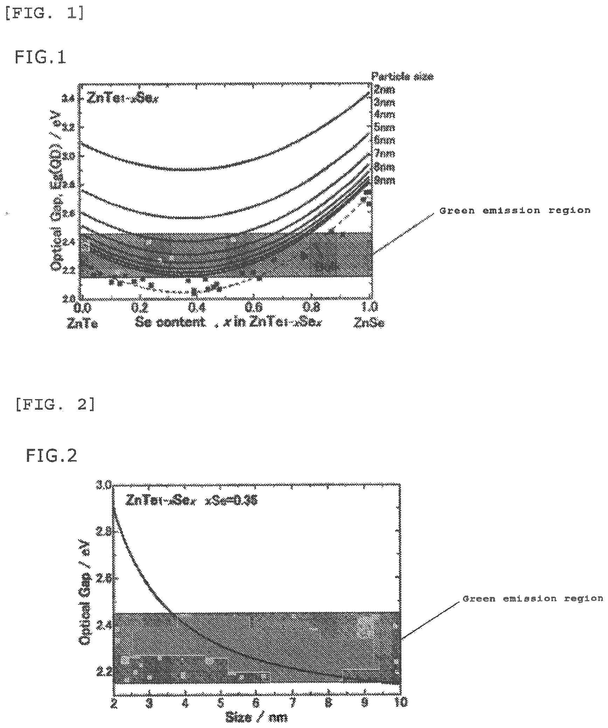

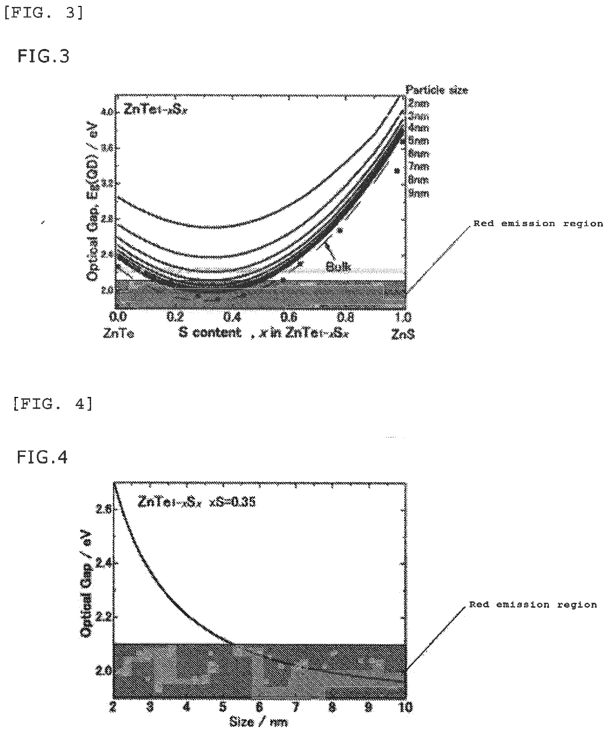

FIG. 1 illustrates a simulation result of a band gap to a molar composition ratio $x_{Se}$ of Se in a $Zn(Te_{1-x}, Se_x)$ colloidal quantum dot having a particle diameter of 2 to 10 nm on the basis of Expressions (1) to (6) above. When the molar composition ratio $x_{Se}$ of Se and the particle diameter are appropriately controlled, a desired energy value which is within a range of optical gap of 2.1 to 3.4 eV, that is, a desired emission color can be achieved. FIG. 2 illustrates a simulation result of a band gap to the particle diameter in a $Zn(Te_{1-x}, Se_x)$ colloidal quantum dot having a molar composition ratio $x_{Se}$ of Se of 0.35. A band portion exhibits a green emission region. In consideration of a general stokes shift of 100 meV, the molar composition ratio $x_{Se}$ of Se and the particle diameter are adjusted. Thus, green emission can be achieved in a Cd-free $Zn(Te_{1-x}, Se_x)$ colloidal quantum dot. FIG. 3 illustrates a simulation result of a band gap to a molar composition ratio $x_S$ of S in a $Zn(Te_{1-x}, S_x)$ colloidal quantum dot having a particle diameter of 2 to 10 nm. When the molar composition ratio $x_S$ of S and the particle diameter are appropriately controlled, a desired energy value which is within a range of optical gap of 1.9 to 4.0 eV, that is, a desired emission color can be achieved. FIG. 4 illustrates a simulation result of a band gap to the particle diameter in a $Zn(Te_{1-x}, S_x)$ colloidal quantum dot having a molar composition ratio $x_S$ of S of 0.35. A band portion exhibits a red emission region. In consideration of a general stokes shift of 100 meV, the molar composition ratio $x_S$ of S and the particle diameter are adjusted. Thus, red emission can be achieved in a Cd-free $Zn(Te_{1-x}, S_x)$ colloidal quantum dot.

[Colloidal Quantum Dot of Embodiment]

A colloidal quantum dot of an embodiment is a Cd-free colloidal quantum dot which is a core particle that is coated with a shell made from a compound semiconductor and serves as a core for the shell, and which can emit visible fluorescence under irradiation with excited light having a wavelength of a near ultraviolet region or a blue region. The colloidal quantum dot is represented by a chemical formula: $A(B1_{1-x1}, B2_x)$ (wherein $0<x<1$), has Zn as a Group-II element in the A site, Te as a Group-VI element in the B1 site, and Se or S as a Group-VI element in the B2 site, and has an average particle diameter of 1 nm or more and 10 nm or less. Herein, the reason why $0<x<1$ is that ZnTe which is obtained when x is 0, and ZnSe or ZnS which is obtained when x is 1 do not achieve the object and effect of the present invention. When the average particle diameter is less than 1 nm, it is difficult to control the particle diameter. When the average particle diameter is more than 10 nm, a very long time is required for particle growth, the production efficiency is deteriorated, the particle size distribution is increased, and the color purity is deteriorated.

The concept of isoelectronic trap was proposed by Thomas et al. in 1965. An isoelectronic trap is one in which when a trace of element (Se) having the same electron configuration as that of an element (e. g. , Zn and Te) constituting a compound semiconductor is doped to replace a lattice point, electrons or holes are attracted due to a difference in electron affinity between the element and the base element (Te), resulting in a bound state. An emission mechanism on the basis of the isoelectronic trap can be described using a configuration coordinate model exhibiting a relationship between displacement of lattice and energy. An exciton which is in an excited state is trapped in a bottom of a potential in the excited state which is formed by bounding. When the exciton is present in the bottom, a difference between the potential of the exciton and a potential in a ground state is decreased. Therefore, transition between the level of the bottom and the level of the ground state causes emission with smaller energy than the band gap of the original compound semiconductor (ZnTe).

In the chemical formula $A(B1_{1-x}, B2_x)$ above, when the B2 site is Se, a $Zn(Te_{1-x}, Se_x)$ colloidal quantum dot is obtained. When the molar composition ratio of Se is changed by an isoelectronic trap, a difference between a bottom of a potential in an excited state where an exciton is trapped and a potential in a ground state is changed. In a case where the elements are combined, green light canbe emitted as visible fluorescence at a certain molar composition ratio. In the chemical formula $A(B1_{1-x}, B2_x)$ above, when the B2 site is S, a $Zn(Te_{1-x}, S_x)$ colloidal quantum dot is obtained. When the molar composition ratio of S is changed by the same mechanism as described above, a difference between a bottom of a potential in an excited state where an exciton is trapped and a potential in a ground state is changed. In a case where the elements are combined, red light can be emitted as visible fluorescence at a certain molar composition ratio.

As a method for producing the colloidal quantum dot of the present invention, a method for producing a $Zn(Te_{1-x}, Se_x)$ colloidal quantum dot capable of emitting green light as visible fluorescence will be described as a first embodiment, and a method for producing a $Zn(Te_{1-x}, S_x)$ colloidal quantum dot capable of emitting red light as visible fluorescence will be described as a second embodiment.

<First Embodiment>

[Method for Producing $Zn(Te_{1-x}, Se_x)$ Colloidal Quantum Dot Capable of Emitting Green Light as Visible Fluorescence]

A method for producing a colloidal quantum dot capable of emitting green light as visible fluorescence of the first embodiment is a method producing a Cd-free colloidal quantum dot capable of emitting green light as visible fluorescence, including heating any one of a liquid prepared by mixing a Zn source liquid, a Te source liquid, and a Se source liquid, and a liquid prepared by mixing a capping agent with a diluent to a temperature of 200°C to 350°C, injecting into the heated liquid a predetermined amount of the other liquid under a nonoxidative atmosphere, adjusting the temperature of the liquid obtained by injecting the other liquid to the heated liquid to 200°C to 350°C, and holding the liquid for one minute to five hours.

As an example, the method of the first embodiment includes steps of (a) mixing a Zn source liquid, a Te source liquid, and a Se source liquid to prepare a first mixed liquid, (b) placing a capping agent and a diluent in a closed container and mixing them to prepare a second mixed liquid, (c) adjusting the temperature of the second mixed liquid to 200°C to 350°C, making the inside of the closed container into a nonoxidative atmosphere, and injecting a predetermined amount of the first mixed liquid into the second mixed liquid, and (d) adjusting the temperature of a liquid obtained by injecting the first mixed liquid into the second mixed liquid to 200°C to 350°C and holding the liquid for one minute to five hours. Herein, the temperature of the second mixed liquid is adjusted to 200°C to 350°C. When the temperature is lower than 200°C, nucleation does not rapidly occur, and the particle size distribution is increased. Further, when the temperature is higher than 350°C, an organic solvent is preferentially volatilized, and it is difficult to produce the colloidal quantum dot. The adjustment temperature of the second mixed liquid is preferably 250°C to 310°C. The temperature of the liquid obtained by injecting the first mixed liquid into the second mixed liquid is adjusted to 200°C to 350°C. When the temperature is lower than 200°C, the growth rate of colloid is very low, and it is very difficult to control the particle diameter over time. Further, when the temperature is higher than 350°C, the organic solvent is preferentially volatilized, and it is difficult to grow the colloidal quantum dot. The holding temperature is preferably 230°C to 300°C. The holding time of the liquid obtained by injecting the first mixed liquid into the second mixed liquid is one minute to five hours. When the time is less than one minute, the sources are hardly consumed, and the yield is largely reduced. When the time is more than five hours, the productivity is deteriorated, and the cost of electric power consumed during heating for growth is largely increased. The holding time is preferably 10 minutes to 60 minutes.

[Preparation of Zn Source Liquid]

The Zn source liquid is prepared by placing liquid diethylzinc (DEZ), powder zinc stearate ($Zn(St)_2$), or the like as a Zn source in a container purged with an inert gas, adding an organic solvent (complex-forming agent) such as trioctylphosphine (TOP), octadecene (ODE), acetic acid, oleic acid (OA), stearic acid, hexadecylamine (HDA), oleylamine (OLA), trioctylamine (TOA), and tributyl phosphate (TBPA) to this container, and heating the mixture . The organic solvent is not limited as long as it is an organic solvent forming a complex with Zn ions. The container including the mixed liquid of the Zn source is heated in an oil bath or the like while an inert gas is bubbled. The temperature heated in the oil bath is 20°C to 350°C, and the holding time at heating temperature is five minutes to five hours. When the heating temperature is lower than 20°C or the holding time is less than five minutes, the Zn source is insufficiently dissolved in the organic solvent (complex-forming agent). Thus, an undissolved Zn source easily remains. When the heating temperature is higher than 350°C, the organic solvent (complex-forming agent) is preferentially volatilized, to fail to dissolve the Zn source. When the holding time is more than five hours, the Zn source sufficiently reaches the solution equilibrium, and electric power is excessively consumed by heating. The organic solvent (complex-forming agent) is added in an amount of 1 to 16 mol relative to 1 mol of the Zn source. When the Zn source is dissolved, the mixed liquid is transparent. The preparation of the Zn source liquid is not limited to the aforementioned preparation condition, and the condition can be controlled depending on a combination of used solvents for forming a complex.

[Preparation of Te Source Liquid]

The Te source liquid is prepared by placing powder metal tellurium (Te), powder oxide tellurium, an available, inexpensive, and safe organic tellurium compound, or the like as a Te source in a container purged with an inert gas, adding the same organic solvent (complex-forming agent) as one used in preparation of Zn source liquid to this container, and heating the mixture. The organic solvent is not limited as long as it is an organic solvent forming a complex with Te ions . The container including the mixed liquid of the Te source is heated in an oil bath or the like while an inert gas is bubbled. The temperature heated in the oil bath is 100°C to 350°C, and the holding time at heating temperature is five minutes to five hours. When the heating temperature is lower than 100°C or the holding time is less than five minutes, the Te source is insufficiently dissolved in the organic solvent (complex-forming agent). Thus, an undissolved Te source easily remains. When the heating temperature is higher than 350°C, the organic solvent (complex-forming agent) is preferentially volatilized, to fail to dissolve the Te source. When the holding time is more than five hours, the Te source sufficiently reaches the solution equilibrium, and electric power is excessively consumed by heating.

[Preparation of Se Source Liquid]

The Se source liquid is prepared by placing powder metal selenium (Se), powder oxide selenium, an available, inexpensive, and safe organic selenium compound, or the like as a Se source in a container purged with an inert gas, adding the same organic solvent (complex-forming agent) as one used in preparation of Zn source liquid to this container, and heating the mixture. The organic solvent is not limited as long as it is an organic solvent forming a complex with Se ions. The container including the mixed liquid of the Se source is heated in an oil bath or the like while an inert gas is bubbled. The temperature heated in the oil bath is 20°C to 350°C, and the holding time at heating temperature is five minutes to five hours. When the heating temperature is lower than 20°C or the holding time is less than five minutes, the Se source is insufficiently dissolved in the organic solvent (complex-forming agent). Thus, an undissolved Se source easily remains. When the heating temperature is higher than 350°C, the organic solvent (complex-forming agent) is preferentially volatilized to fail to dissolve the Se source. When the holding time is more than five hours, the Se source sufficiently reaches the solution equilibrium, and electric power is excessively consumed by heating. The organic solvent (complex-forming agent) is added in an amount of 1 to 10 mol relative to 1 mol of the Se source. When the Se source is dissolved, the mixed liquid is transparent. The preparation of the Se source liquid is not limited to the aforementioned preparation condition, and the condition can be controlled depending on a combination of used solvents for forming a complex.

[Preparation of First Mixed Liquid for Preparation of $Zn(Te_{1-x}, Se_x)$ Colloidal Quantum Dot]

The first mixed liquid is prepared by mixing the Zn source liquid, the Te source liquid, and the Se source liquid at a predetermined molar composition ratio in a container purged with an inert gas, and stirring the mixture while an inert gas is bubbled at room temperature.

[Preparation of Second Mixed Liquid for Preparation of $Zn(Te_{1-x}, Se_x)$ Colloidal Quantum Dot]

The second mixed liquid is prepared by mixing the capping agent and the diluent in the container, performing a deaeration treatment in vacuum "at 120°C for 30 minutes" with stirring, returning the pressure to atmospheric pressure using an inert gas, and heating the mixture to 200°C to 350°C by a mantle heater or the like while an inert gas is bubbled. Examples of the capping agent include trioctylphosphine (TOP), oleic acid (OA), stearic acid, hexadecylamine (HDA), oleylamine (OLA), tributyl phosphate (TBPA), and trioctylphosphine oxide (TOPO). Examples of the diluent include trioctylphosphine (TOP), octadecene (ODE), oleylamine (OLA), hexadecylamine (HDA), and trioctylphosphine oxide (TOPO). The diluent is added in an amount of 1 to 5 mol relative to 1 mol of the capping agent.

[Injection of Second Mixed Liquid into First Mixed Liquid]

After the temperature of the second mixed liquid which is heated to 200°C to 350°C by the mantle heater or the like is stable, the first mixed liquid (at room temperature) is injected once into the second mixed liquid by a syringe or the like, to produce a nuclear of the colloidal quantum dot. Specifically, the injection is performed by a syringe with an inner diameter of 10 mm at a pushing speed of 1 to 20 mL/second. When the injection is slowly performed at a speed lower than the lower limit value, the nuclear is produced over time. Therefore, the particle size distribution is increased. When the speed is higher than the upper limit value, an injection operation is technically difficult. As described above, the mixed liquid of the Zn source liquid, the Te source liquid, and the Se source liquid is prepared. As a method for mixing the first mixed liquid with the second mixed liquid, a mixing method such as nozzle mixing and ejector mixing using an inert compressed gas according to the scale of mixing may be used. Herein, the temperature of the second mixed liquid is adjusted to 200°C to 350°C. When the temperature is lower than 200°C, nucleation does not rapidly occur, and the particle size distribution is increased. Further, when the temperature is higher than 350°C, the organic solvent is preferentially volatilized, to fail to produce the nuclear of the colloidal quantum dot.

[Nucleus Growth after Injection]

After the first mixed liquid (at room temperature) is injected once into the second mixed liquid by the syringe or the like, the temperature of the solution rapidly decreases . The temperature of the solution is held at 200°C to 350°C for one minute to five hours, to grow the colloidal quantum dot. After the solution is held for a predetermined time, the solution is allowed to cool to room temperature. The reaction solution becomes a transparent solution without cloud. When the temperature of the solution is lower than 200°C, the growth rate of colloid is very low, and it is very difficult to control the particle diameter over time. Further, when the temperature is higher than 350°C, the organic solvent is preferentially volatilized, to fail to grow the colloidal quantum dot. When the time is less than one minute, the sources are hardly consumed, and the yield is largely reduced. When the time is more than five hours, the productivity is deteriorated, and the cost of electric power consumed during heating for growth is largely increased.

When the temperature of the second mixed liquid, and the temperature and the holding time of the solution after injection of the first mixed liquid into the second mixed liquid are adjusted, the average particle diameter of the colloidal quantum dot to be obtained can be made constant. When the average particle diameter is adjusted to $4.0 \pm 0.1$ nm and the molar preparation ratio $x_{Se}$ of Se in the first mixed liquid is changed, that is, the molar composition ratio $x_{Se}$ of Se in the colloidal quantum dot is changed, a band gap bowing effect is observed. A value of band gap at $x_{Se}$ of about 0.30 exhibits a minimum value of about 2.4 eV. Subsequently, when the molar composition ratio $x_{Se}$ of Se is fixed to about 0.30 and the temperature of the second mixed liquid, and the temperature and the holding time of the solution after injection of the first mixed liquid into the second mixed liquid are adjusted, the average particle diameter of the colloidal quantum dot can be adjusted to a range of 3.0 to 7.0 nm. Due to a quantum size effect, the band gap of the colloidal quantum dot is changed. Thus, green emission (2.15 to 2.45 eV) is achieved at a region where the average particle diameter is 3.0 to 7.0 nm.

<Second Embodiment>

[Method for Producing $Zn(Te_{1-x}, S_x)$ Colloidal quantum dot capable of Emitting red light as Visible Fluorescence]

A method for producing a colloidal quantum dot capable of emitting red light of the second embodiment is a method producing a Cd-free colloidal quantum dot capable of emitting red light as visible fluorescence, including heating any one of a liquid prepared by mixing a Zn source liquid and a Te source liquid, and a liquid prepared by mixing a S source liquid, a capping agent, and a diluent to a temperature of 200°C to 350°C, injecting into the heated liquid a predetermined amount of the other liquid under a nonoxidative atmosphere, adjusting the temperature of the liquid obtained by injecting the other liquid to the heated liquid to 200°C to 350°C, and holding the liquid for one minute to five hours.

As an example, the producing method of the second embodiment includes steps of (a) mixing a Zn source liquid and a Te source liquid to prepare a third mixed liquid, (b) mixing a S source liquid, a capping agent, and a diluent in a closed container to prepare a fourth mixed liquid, (c) adjusting the temperature of the fourth mixed liquid to 200°C to 350°C, making the inside of the closed container into a nonoxidative atmosphere, and injecting a predetermined amount of the third mixed liquid into the fourth mixed liquid, and (d) adjusting the temperature of a liquid obtained by injecting the third mixed liquid into the fourth mixed liquid to 200°C to 350°C and holding the liquid for one minute to five hours. Herein, the temperature of the fourth mixed liquid is adjusted to 200°C to 350°C. When the temperature is lower than 200°C, nucleation does not rapidly occur, and the particle size distribution is increased. Further, when the temperature is higher than 350°C, an organic solvent is preferentially volatilized, to fail to produce the colloidal quantum dot. The adjustment temperature of the fourth mixed liquid is preferably 260°C to 320°C. The temperature of the liquid obtained by injecting the third mixed liquid into the fourth mixed liquid is adjusted to 200°C to 350°C. When the temperature is lower than 200°C, the growth rate of the colloidal quantum dot is very low, and it is very difficult to control the particle diameter over time. Further, when the temperature is higher than 350°C, the organic solvent is preferentially volatilized, to fail to grow the colloidal quantum dot. The holding temperature is preferably 240°C to 310°C. The holding time of the liquid obtained by injecting the third mixed liquid into the fourth mixed liquid is one minute to five hours. When the time is less than one minute, the sources are hardly consumed, and the yield is largely reduced. When the time is more than five hours, the productivity is deteriorated, and the cost of electric power consumed during heating for growth is largely increased. The holding time is preferably ten minutes to three hours.

[Preparation of Zn Source Liquid]

The Zn source liquid is prepared in the same manner as the Zn source liquid used in the aforementioned method for producing a $Zn(Te_{1-x}, Se_x)$ colloidal quantum dot. The organic solvent (complex-forming agent) is added in an amount of 1 to 16 mol relative to 1 mol of the Zn source. When the Zn source is dissolved, the mixed liquid is transparent. The preparation of the Zn source liquid is not limited to the aforementioned preparation condition, and the condition can be controlled depending on a combination of used solvents for forming a complex.

[Preparation of Te Source Liquid]

The Te source liquid is prepared in the same manner as the Te source liquid used in the aforementioned method for producing a $Zn(Te_{1-x}, Se_x)$ colloidal quantum dot.

[Preparation of S Source Liquid]

The S source liquid is prepared by placing powder sulfur (S), an available, inexpensive, and safe organic sulfur compound, or the like as a S source in a container purged with an inert gas, adding the same organic solvent (complex-forming agent) as one used in preparation of Zn source liquid to this container, and heating the mixture. The organic solvent is not limited as long as it is an organic solvent forming a complex with S ions. The container including the mixed liquid of the S source is heated in an oil bath or the like while an inert gas is bubbled. The temperature heated in the oil bath is 20°C to 350°C, and the holding time at heating temperature is five minutes to five hours. When the heating temperature is lower than 20°C or the holding time is less than five minutes, the S source is insufficiently dissolved in the organic solvent (complex-forming agent). Thus, an undissolved S source easily remains. When the heating temperature is higher than 350°C, the organic solvent (complex-forming agent) is preferentially volatilized, to fail to dissolve the S source. When the holding time is more than five hours, the S source sufficiently reaches the solution equilibrium, and electric power is excessively consumed by heating. The organic solvent (complex-forming agent) is added in an amount of 1 to 10 mol relative to 1 mol of the S source. When the S source is dissolved, the mixed liquid is transparent. The preparation of the S source liquid is not limited to the aforementioned preparation condition, and the condition can be controlled depending on a combination of used solvents for forming a complex.

[Preparation of Third Mixed Liquid for Preparation of $Zn(Te_{1-x}, S_x)$ Colloidal Quantum Dot]

The third mixed liquid is prepared by mixing the Zn source liquid and the Te source liquid at a predetermined molar composition ratio in a container purged with an inert gas, and stirring the mixture while an inert gas is bubbled at room temperature.

[Preparation of Fourth Mixed Liquid for Preparation of $Zn(Te_{1-x}, S_x)$ Colloidal Quantum Dot]

The fourth mixed liquid is prepared by mixing the S source liquid, the capping agent, and the diluent in the container, performing a deaeration treatment in vacuum "at 120°C for 30 minutes" with stirring, returning the pressure to atmospheric pressure using an inert gas, and heating the mixture to 200°C to 350°C by a mantle heater or the like while an inert gas is bubbled. Examples of the capping agent include trioctylphosphine (TOP), oleic acid (OA), stearic acid, hexadecylamine (HDA), oleylamine (OLA), tributyl phosphate (TBPA), and trioctylphosphine oxide (TOPO) . Examples of the diluent include trioctylphosphine (TOP), octadecene (ODE), oleylamine (OLA), hexadecylamine (HDA), and trioctylphosphine oxide (TOPO). The capping agent is added in an amount of 5 to 30 mol relative to 1 mol of the S source. The diluent is added in amount of 1 to 30 mol relative to 1 mol of the S source.

[Injection of Third Mixed Liquid into Fourth Mixed Liquid]

After the temperature of the fourth mixed liquid increased to 200°C to 350°C by the mantle heater or the like is stable, the third mixed liquid (at room temperature) is injected once into the fourth mixed liquid by a syringe or the like, to produce a nuclear of the colloidal quantum dot. Specifically, the injection is performed by a syringe with an inner diameter of 10 mm at a pushing speed of 1 to 20 mL/second. When the injection is slowly performed at a speed lower than the lower limit value, the nuclear is produced over time. Therefore, the particle size distribution is increased. When the speed is higher than the upper limit value, an injection operation is technically difficult. As described above, a synthesis liquid in which the Zn source liquid, the Te source liquid, and the S source liquid are mixed is prepared. As a method for mixing the third mixed liquid with the fourth mixed liquid, a mixing method such as nozzle mixing and ejector mixing using an inert compressed gas according to the scale of mixing may be used. Herein, the temperature of the fourth mixed liquid is adjusted to 200°C to 350°C. When the temperature is lower than 200°C, nucleation does not rapidly occur, and the particle size distribution is increased. Further, when the temperature is higher than 350°C, the organic solvent is preferentially volatilized, to fail to produce the colloidal quantum dot.

[Nucleus Growth after Injection]

After the third mixed liquid (at room temperature) is injected once into the fourth mixed liquid by the syringe or the like, the temperature of the solution rapidly decreases . The temperature of the solution is held at 200°C to 350°C for one minute to five hours, to grow the colloidal quantum dot. After the solution is held for a predetermined time, the solution is allowed to cool to room temperature. The reaction solution becomes a transparent solution without cloud. When the temperature of the solution is lower than 200°C, the growth rate of the colloidal quantum dot is very low, and it is very difficult to control the particle diameter over time. Further, when the temperature is higher than 350°C, the organic solvent is preferentially volatilized, to fail to grow the colloidal quantum dot. When the time is less than one minute, the sources are hardly consumed, and the yield is largely reduced. When the time is more than five hours, the productivity is deteriorated, and the cost of electric power consumed during heating for growth is largely increased.

When the temperature of the fourth mixed liquid, and the temperature and the holding time of the solution after injection of the third mixed liquid into the fourth mixed liquid are adjusted, the average particle diameter of the colloidal quantum dot to be obtained can be made constant.

When the average particle diameter is adjusted to 7.0±0.1 nm and the molar preparation ratio $x_S$ of S in the fourth mixed liquid is changed, that is, the molar composition ratio $x_S$ of S in the colloidal quantum dot is changed, a band gap bowing effect is observed. A value of band gap at $x_S$ of about 0.30 exhibits a minimum value of about 2.0 eV. Subsequently, the average particle diameter of the colloidal quantum dot is adjusted to a range of 5.0 to 9.0 nm. Due to a quantum size effect, the band gap of the colloidal quantum dot is changed to achieve red emission (1.80 to 2.10 eV).

Hereinafter, Examples of the present invention will be described in detail with Comparative Examples.

Raw materials used in Examples and Comparative Examples of the present invention are as follows.

[Raw Materials]

The following reagents were prepared. All the reagents were used in a commercial state without purification.

(1) Diethylzinc (DEZ, ≥52 wt% Zn basis, Aldrich)
(2) Selenium powder (Se, 100 mesh, 99.99%, trace metal basis, Aldrich)
(3) Tellurium powder (Te, 100 mesh, 99.99%, trace metal basis, Aldrich)
(4) Tri-n-octylphosphine (TOP, ≥96.0%, Wako Pure Chemical Industries, Ltd.)
(5) Oleylamine (OLA, >98%, Aldrich)
(6) Oleic acid (OA, 99%, Aldrich)
(7) 1-octadecene (ODE, >90%, Tokyo Chemical Industry Co., Ltd.)
(8) 1-dodecanethiol (DDT, >95%, Tokyo Chemical Industry Co., Ltd.)
(9) Hexane (>96%, Wako Pure Chemical Industries, Ltd.)
(10) Ethanol (96%, IMAZU CHEMICAL Co., Ltd.)
(11) Zinc acetate anhydrous (99.99%, Aldrich)
(12) Indium acetate (99.99%, Aldrich)
(13) Palmitic acid (95%, Wako Pure Chemical Industries, Ltd.)
(14) Tris(trimethylsilyl) phosphine (10 wt% hexane solution, Stream Chemicals)
(15) Isopropanol (>99.7%, Kanto Chemical Co., Inc.)
(16) Toluene (>99.5%, Kanto Chemical Co., Inc.)
(17) Zinc diethyldithiocarbamate (>94%, Wako Pure Chemical Industries, Ltd.)
(18) Copper iodide (95%, Wako Pure Chemical Industries, Ltd.)
(19) Indium iodide (99.998%, Aldrich)
(20) cadmium acetate dihydrate (99.9%, Wako Pure Chemical Industries, Ltd.)
(21) Octylamine (98%, Wako Pure Chemical Industries, Ltd.)
(22) Butanol (99%, Wako Pure Chemical Industries, Ltd.)
(23) Methanol (>99.8%, Kanto Chemical Co., Inc.)
(24) Zinc stearate (10 to 11% (Zn), Wako Pure Chemical Industries, Ltd.)
(25) Sulfur powder (99.98%, Aldrich)

Hereinafter, Examples 1 to 12 and Comparative Examples 1 to 5 will be described in accordance with the first embodiment.

<Example 1>

[Synthesis of $Zn(Te_{1-x}, Se_x)$ Colloidal Quantum Dot]

For synthesis of a $Zn(Te_{1-x}, Se_x)$ colloidal quantum dot, a series of operations from weighting of the reagents to completion of synthesis was performed in a glove box which was mainly filled with a nitrogen gas. Some operations outside the glove box were performed in a closed container filled with a nitrogen gas so that a solution was not in contact with air.

[Preparation of Source Solution]

1.9142 g (15 mmol) of Te powder and 50 mL of TOP were weighed in a three-neck flask, then heated to 250°C while an argon gas was bubbled, and stirred until the Te powder was completely dissolved to be yellow transparent. After the dissolution, the solution was allowed to cool to room temperature, to obtain a Te source liquid. 1.1845 g (15 mmol) of Se powder and 50 mL of TOP were weighed in a vial and placed in an ultrasonic cleaner, and the Se powder was completely dissolved to obtain a colorless transparent Se source liquid. The Te source liquid, the Se source liquid, TOP, and DEZ were each weighed so that the molar composition ratio $x_{Se}$ of Se of a colloidal quantum dot was 0.40, and sufficiently mixed in a 10-mL vial, to obtain a source solution. Herein, a Zn source liquid, the Te source liquid, and the Se source liquid can be separately prepared. Since DEZ was a liquid, TOP and DEZ were mixed in and dissolved in the Te source liquid and the Se source liquid, to obtain a first mixed liquid.

[Procedure for Synthesis of $Zn(Te_{1-x}, Se_x)$ Colloidal Quantum Dot]

6.48 mL (20 mmol) of OA as a capping agent and 20 mL of ODE as a diluent were each weighed and mixed in a 100-mL four necked flask, to prepare a second mixed liquid. While this second mixed liquid was stirred, this second mixed liquid was subjected to a deaeration treatment in vacuum "at 120°C for 30 minutes. " The pressure of the second mixed liquid was then returned to atmospheric pressure using an argon gas, and the second mixed liquid was heated to 290°C with stirring while an argon gas was bubbled. It was confirmed that the temperature of the second mixed liquid was stable . After then, the first mixed liquid was rapidly injected into the second mixed liquid by a syringe. The reaction solution after the injection was held at a temperature of 270°C for 10 minutes with stirring, to grow a colloidal quantum dot. The colloidal quantum dot was allowed to cool to room temperature. The reaction solution was a transparent solution without cloud. Herein, conditions for adjustment of the average particle diameter to 4.0±0.1 nm are that the temperature of the second mixed liquid is heated to 290°C, the growth temperature after injection of the first mixed liquid into the second mixed liquid is 270°C, and the growth time at this temperature is 10 minutes. When the temperature of the second mixed liquid, the growth temperature after injection of the first mixed liquid into the second mixed liquid, and the growth time at this temperature are adjusted, the particle diameter of the colloidal quantum dot can be adjusted. These conditions are shown in Table 2 below.

[Table 2]

| | $X_{Se}$ (Preparation) | Temperature of second mixed liquid [°C] | Growth temperature [°C] | Growth time [min] | Optical gap [eV] | Emission energy [eV] | Average particle diameter [nm] |
|---|---|---|---|---|---|---|---|
| Example 1 | 0.40 | 290 | 270 | 10 | 2.43 | 2.33 | 4.1 |
| Example 2 | 0.35 | 290 | 270 | 10 | 2.43 | 2.33 | 4.0 |
| Example 3 | 0.30 | 290 | 270 | 30 | 2.41 | 2.31 | 4.0 |
| Example 4 | 0.25 | 290 | 270 | 10 | 2.42 | 2.32 | 3.9 |
| Example 5 | 0.10 | 270 | 250 | 20 | 2.52 | 2.42 | 3.9 |
| Comparative Example 1 | 0.00 | 270 | 250 | 30 | 2.59 | 2.49 | 4.0 |
| Comparative Example 2 | 1.00 | 280 | 280 | 9 | 3.03 | 2.93 | 4.1 |

[Extraction of $Zn(Te_{1-x}, Se_x)$ Colloidal Quantum Dot]

To 12 mL of the reduction reaction thus obtained, 6 mL of hexane and 18 mL of ethanol were added, resulting in aggregation. The colloidal quantum dot was separated and collected as a precipitate by centrifugation. The precipitate was dispersed again in 6 mL of hexane, and 18 mL of ethanol was added again, resulting in aggregation. This operation was repeated several times, and the aggregate was dried under vacuum at room temperature to remove residual hexane and ethanol. As a result, the colloidal quantum dot was extracted.

[Growth of ZnS Shell]

The thus obtained $Zn(Te_{1-x}, Se_x)$ colloidal quantum dot was mixed with 1 mL of OLA, 2 mL of TOP, and 10 mL of ODE, and the mixture was subjected to a deaeration treatment in vacuum "at 100°C for 30 minutes" with stirring. The pressure of the mixture was then returned to atmospheric pressure using an argon gas, and the mixture was heated to 240°C with stirring while an argon gas was bubbled. To the mixture, a solution (about 6 mL) obtained by mixing 0.034 mL of DEZ, 0.073 mL of DDT, and 6 mL of ODE was added dropwise over 30 minutes. At that time, the temperature of the solution was held at 240°C. After completion of dropwise addition, the solution was held at 240°C for 15 minutes, and allowed to cool to room temperature.

[Extraction of $Zn(Te_{1-x}, Se_x)$ /ZnS Core-Shell Colloidal Quantum Dot]

To 2 mL of the reaction solution thus obtained, 1 mL of hexane and 3 mL of ethanol were added, resulting in aggregation. The colloidal quantum dot was separated and collected as a precipitate by centrifugation. The precipitate was dispersed again in 1 mL of hexane, and 3 mL of ethanol was added again, resulting in aggregation. This operation was repeated several times, and the aggregate was dried under vacuum at room temperature to remove residual hexane and ethanol. As a result, a core-shell colloidal quantum dot was extracted.

<Examples 2 to 5 and Comparative Example 1>

In Examples 2 to 5 and Comparative Example 1, the same Te source liquid, Se source liquid, TOP, DEZ, and the like as those in Example 1 were used. In Examples 2 to 5 and Comparative Example 1, the Te source liquid, the Se source liquid, TOP, DEZ, and the like were weighed so that the molar composition ratio $x_{Se}$ of Se of a colloidal quantum dot was as shown in Table 2 above. Further, the temperature of the second mixed liquid, the growth temperature after injection of the first mixed liquid into the second mixed liquid, and the growth time at this temperature were adjusted. Thus, the particle diameter of the colloidal quantum dot was adjusted. A $Zn(Te_{1-x}, Se_x)$/ZnS core-shell colloidal quantum dot was synthesized in the same manner as in Example 1 except for aforementioned points.

<Comparative Example 2>

[Synthesis of ZnSe Colloidal Quantum Dot]

[Preparation of Source Solution]

18.3 mg (0.1 mmol) of zinc acetate anhydrous, 3.5 mL (10.91 mmol) of ODE, and 0.330 mL '(1.00 mmol) of OLA were weighed in a 10-mL vial, and stirred by a shaker warmed to 60°C, and zinc acetate anhydrous was completely dissolved to prepare a colorless transparent Zn source liquid. 63.2 mg (0.8 mmol) of Se powder and 2.0 ml (4.48 mmol) of TOP were weighed in another 10-mL vial so that the molar composition ratio $x_{Se}$ of Se of a colloidal quantum dot was 1.00. The Se powder was completely dissolved in an ultrasonic cleaner, to prepare a colorless transparent Se source liquid.

[Procedure for Synthesis of ZnSe Colloidal Quantum Dot]

In a 10-mL vial including the Zn source liquid, 1.5 mL of the Se source liquid was placed, and the mixture was sufficiently stirred. The vial was immersed in an oil bath heated to 280°C, and held for 9 minutes while an argon gas was bubbled. The vial was then taken out from the oil bath, and allowed to cool to room temperature. The reaction solution was a light yellow transparent solution.

[Extraction of ZnSe Colloidal Quantum Dot from Reaction Solution]

Extraction of the ZnSe colloidal quantum dot from the reaction solution was performed by the same procedure as that for the $Zn(Te_{1-x}, Se_x)$ colloidal quantum dot.
In Comparative Example 2, a ZnSe/ZnS core-shell colloidal quantum dot was synthesized in the same manner as in Example 1 except for aforementioned points. The molar composition ratio $x_{Se}$ of Se of the colloidal quantum dot in Comparative Example 2, the temperature of the second mixed liquid, the growth temperature after injection of the first mixed liquid into the second mixed liquid, and the growth time at this temperature are shown in Table 2 above.

<Example 6>

The same Te source liquid, Se source liquid, TOP, and DEZ as in Example 1 were each weighed so that the molar composition ratio $x_{Se}$ of Se of a colloidal quantum dot was 0.30, and sufficiently mixed in a 10-mL vial, to obtain a first mixed liquid. On the other hand, a second mixed liquid which was the same mixed solution of OA and ODE as in Example 1 was heated to 310°C with stirring while an argon gas was bubbled. It was confirmed that the temperature of the second mixed liquid was stable. After then, the first mixed liquid was rapidly injected into the second mixed liquid by a syringe. The reaction solution after the injection was held at a temperature of 290°C for 10 minutes with stirring, to grow the colloidal quantum dot. The colloidal quantum dot was allowed to cool to room temperature. A $Zn(Te_{1-x}, Se_x)/ZnS$ core-shell colloidal quantum dot was synthesized in the same manner as in Example 1 except for aforementioned points. The molar composition ratio $x_{Se}$ of Se of the colloidal quantum dot, the temperature of the second mixed liquid, the growth temperature after injection of the first mixed liquid into the second mixed liquid, and the growth time at this temperature are shown in Table 3 below.

[Table 3]

| | $X_{Se}$ (Preparation) | Temperature of second mixed liquid [°C] | Growth temperature [°C] | Growth time [min] | Optical gap [eV] | Emission energy [eV] | Average particle diameter [nm] | Matching to extension of green region |
|---|---|---|---|---|---|---|---|---|
| Example 6 | 0.30 | 310 | 290 | 10 | 2.36 | 2.26 | 4.7 | Not matched |
| Example 7 | 0.30 | 310 | 290 | 30 | 2.34 | 2.24 | 5.3 | Not matched |
| Example 8 | 0.30 | 310 | 290 | 60 | 2.31 | 2.21 | 6.0 | Not matched |
| Example 9 | 0.30 | 250 | 230 | 10 | 2.51 | 2.41 | 3.5 | Not matched |
| Example 10 | 0.30 | 290 | 270 | 30 | 2.41 | 2.31 | 4.1 | Not matched |
| Example 11 | 0.30 | 290 | 270 | 10 | 2.43 | 2.33 | 3.9 | Matched |
| Example 12 | 0.30 | 310 | 300 | 30 | 2.29 | 2.19 | 6.3 | Not matched |

<Examples 7 to 12>

In Examples 7 to 12, the same Te source liquid, Se source liquid, TOP, DEZ, and the like as those in Example 1 were used. In Examples 7 to 12, the Te source liquid, the Se source liquid, TOP, DEZ, and the like were weighted so that the molar composition ratio $x_{Se}$ of Se of a colloidal quantum dot was as shown in Table 3 above, and the temperature of the second mixed liquid, the growth temperature after injection of the first mixed liquid into the second mixed liquid, and the growth time at this temperature were adjusted. Thus, the particle diameter of the colloidal quantum dot was adjusted. A $Zn(Te_{1-x}, Se_x)$/ZnS core-shell colloidal quantum dot was synthesized in the same manner as in Example 6 except for aforementioned points.

<Comparative Example 3>

[Synthesis of InP/ZnS Colloidal Quantum Dot]

[Synthesis of InP Core Colloidal Quantum Dot]

0.04 mmol of indium acetate ($In(C_2H_3O_2)_3$) was added to 0.12 mmol of palmitic acid ($C_{16}H_{32}O_2$) and 2 mL of ODE ($C_{18}H_{36}$), and the mixture was heated to 110°C while stirring, and subjected to a vacuum treatment for 1.5 hours, to prepare an In source liquid. On the other hand, 0.02 mmol of tris(trimethylsilyl)phosphine ($P(SiC_3H_9)_3$) was dissolved in 3 mL of ODC ($C_{18}H_{36}$) to prepare a P source liquid. The pressure of the In source liquid was returned to atmospheric pressure using an argon gas, and the In source liquid was heated to 300°C with stirring while an argon gas was bubbled. Into the heated In source liquid, a predetermined amount of the P source liquid was rapidly injected by a syringe, and immediately quenched to room temperature, to prepare an InP core colloidal quantum dot reaction solution.

[Growth of ZnS Shell]

To the InP core colloidal quantum dot reaction solution, 0.1 mmol of zinc acetate ($Zn(C_2H_3O_2)_3$) was added, and the mixture was heated to 230°C with stirring, and held for several hours . Into the heated and held liquid, 0.04 mmol of 1-dodecanethiol ($C_{12}H_{26}S$) was rapidly injected, and the mixture was held for one hour, to prepare an InP/ZnS core-shell colloidal quantum dot reaction solution.

[Cleaning and Collection]

The InP/ZnS core-shell colloidal quantum dot reaction solution was cooled to room temperature, and to the cooled solution, 40 mL of isopropanol ($C_3H_8O$) was added to aggregate an InP/ZnS core-shell colloidal quantum dot. A precipitate was collected by centrifugation, and dispersed again by an appropriate amount of toluene ($C_7H_8$). A series of processes including aggregation by isopropanol, collection by centrifugation, and redispersion by toluene were repeated several times. The precipitation finally obtained by centrifugation was dried under vacuum at room temperature to remove a residual organic solvent. As a result, the InP/ZnS core-shell colloidal quantum dot was obtained.

<Comparative Example 4>

[Synthesis of CuInS$_2$-ZnS Alloy/ZnS Colloidal Quantum Dot]

[Synthesis of CuInS$_2$-ZnS Alloy Colloidal Quantum Dot]

0.25 mmol of zinc diethyldithiocarbamate ($C_{10}H_{20}N_2S_4Zn$) was dissolved in 3.0 mL of TOP ($P(C_8H_{17})_3$) at room temperature, and 1.0 mL of the solution was taken and mixed with 4.0 mL of ODE ($C_{18}H_{36}$). The mixture was a zinc-sulfur solution. 0.1 mmol of copper iodide (CuI) was dissolved in 3.0 mL of OLA ($C_{18}H_{37}N$) at 60°C. This solution was a Cu solution. 0.1 mmol of indium iodide (InI$_3$) was dissolved in 3.0 mL of OLA at room temperature. This solution was an In solution. 2.5 mL of the zinc-sulfur solution, 1.25 mL of the copper solution, and 1.25 mL of the In solution were weighed and mixed. The mixture was heated to 200°C while an argon gas was bubbled. The mixture was maintained for 60 seconds as it was, to prepare a CuInS$_2$-ZnS alloy core colloidal quantum dot reaction solution.

[Growth of ZnS Shell]

From 1.0 mL of the CuInS$_2$-ZnS alloy core colloidal quantum dot reaction solution, 2.26 mg of CuInS$_2$-ZnS alloy core colloidal quantum dot was extracted. For growth of a very thin zinc sulfide shell, the CuInS$_2$-ZnS alloy core

colloidal quantum dot was dispersed again in 1.5 mL of mixed solution of TOP and ODE having a zinc diethyldithiocarbamate concentration of 5.5 mM containing 32 μL of OA ($C_{18}H_{34}O_2$) as a capping agent. For growth of a relatively thin zinc sulfide shell, the $CuInS_2$-ZnS alloy core colloidal quantum dot was dispersed again in 2.0 mL of mixed solution of TOP and ODE having a zinc diethyldithiocarbamate concentration of 35.3 mM containing 210 μL of oleic acid ($C_{18}H_{34}O_2$) as a capping agent. The aforementioned mixtures were reacted at 140°C for five hours, to prepare a $CuInS_2$-ZnS alloy/ZnS core-shell colloidal quantum dot reaction solution.

[Cleaning and Collection]

The $CuInS_2$-ZnS alloy/ZnS core-shell colloidal quantum dot reaction solution was cooled to room temperature, and to the cooled solution, 40 mL of isopropanol ($C_3H_8O$) was added to aggregate a $CuInS_2$-ZnS alloy/ZnS core-shell colloidal quantum dot. A precipitate was collected by centrifugation, and dispersed again by an appropriate amount of toluene ($C_7H_8$). A series of processes including aggregation by isopropanol, collection by centrifugation, and redispersion by toluene were repeated several times. The precipitate finally obtained by centrifugation was dried under vacuum at room temperature to remove a residual organic solvent. As a result, the $CuInS_2$-ZnS alloy/ZnS core-shell colloidal quantum dot was obtained.

<Comparative Example 5>

[Synthesis of CdSe/ZnS Colloidal Quantum Dot]

[Synthesis of CdSe Colloidal Quantum Dot Used as Core]

(Preparation of Cd Source Liquid)

42.6 mg (0.16 mmol) of cadmium acetate dihydrate powder was weighed in a 12-mL screw cap bottle, and 264 μL of OA and 8.0 mL of ODE were added. The mixture was heated in an oil bath of 180°C for 60 minutes, to dissolve the powder. As a result, a Cd source liquid was prepared. This Cd source liquid was colorless and transparent.

(Preparation of Se Source Liquid)

94.8 mg (1.2 mmol) of Se powder was weighed in a 12-mL screw cap bottle, 5.0 mL of TOP was added, and the mixture was stirred by a tube mixer using ultrasonic wave. The powder was simply dissolved to prepare a Se source liquid. This Se source liquid was colorless and transparent.

(Mixing and Reaction of Cd Source Liquid and Se Source Liquid)

2.0 mL of the Cd source liquid and 1.0 mL of the Se source liquid were each placed and mixed in a 12-mL screw cap bottle . As a capping agent, 150 μL of octylamine was added. The mixture was sufficiently stirred by a tube mixer, and immersed in an oil bath of 280°C. A heating reaction was performed for a predetermined time until particles were grown to a particle diameter in which green light was emitted.

[Collection of CdSe Core Colloidal Quantum Dot from Colloidal Solution after Synthesis]

About 3.0 mL of the reaction solution was placed in a test tube, and diluted with butanol in an amount which was four times the amount of the reaction solution (12.0 mL). To this diluted solution, methanol was then added in an amount which was two times the amount of the reaction solution (6.0 mL), to aggregate a quantum dot. Centrifugation was performed for 15 minutes to separate the diluted solution into a colorless transparent supernatant solution and a red precipitate. The supernatant solution was removed.

[Preparation of ZnS Source Liquid for Coating]

(Coating using Zn(st)$_2$ as Zn Source and Dodecanethiol as S Source)

31.6 mg (0.05 mmol) of Zn(st)$_2$ was weighed in a 12-mL screw cap bottle, and 2.0 mL of ODE was added. The solution was heated in an oil bath of 140°C for 10 minutes, to melt the powder. The screw cap bottle was drawn and cooled to room temperature to reprecipitate the powder, but the solution was used as it was. For S, dodecanethiol was used as a solvent and a S source.

[Redispersion, Mixing, and Coating Treatments in ZnS Source Liquid]

(Redispersion and Mixing)

To a test tube including the precipitation of the CdSe core colloidal quantum dot, 2.0 mL of the S source liquid was added, resulting in redispersion. The resultant was placed in a vial including the prepared Zn source liquid. It was expected that dodecanethiol acted as a capping agent, and so the capping agent was not added.

(Heating and Coating Treatments)

A start solution was heated in an oil bath of 210°C for 120 minutes.

[Cleaning and Collection]

The CdSe/ZnS core-shell colloidal quantum dot reaction solution was cooled to room temperature, and to the cooled solution, 40 mL of isopropanol ($C_3H_8O$) was added to aggregate a CdSe/ZnS core-shell colloidal quantum dot. A precipitate was collected by centrifugation, and dispersed again by an appropriate amount of toluene ($C_7H_8$). A series of processes including aggregation by isopropanol, collection by centrifugation, and redispersion by toluene were repeated several times. The precipitate finally obtained by centrifugation was dried under vacuum at room temperature to remove a residual organic solvent. As a result, the CdSe/ZnS core-shell colloidal quantum dot was synthesized.
Hereinafter, Examples 13 to 24 and Comparative Examples 6 to 9 will be described in accordance with the second embodiment.

<Example 13>

[Synthesis of $Zn(Te_{1-x}, S_x)$ Colloidal Quantum Dot]

For synthesis of a $Zn(Te_{1-x}, S_x)$ colloidal quantum dot, a series of operations from weighing of reagents to completion of synthesize was performed in a glove box which was mainly filled with a nitrogen gas in the same manner as in Example 1. Some operations outside the glove box were performed in a closed container filled with a nitrogen gas so that a solution was not in contact with air in the same manner as in Example 1.

[Preparation of Te Source Liquid]

114.8 mg (0.90 mmol) of Te powder and 3.00 mL (6.72 mmol) of TOP were weighed in a 10-mL septum vial, then heated to 200°C while an argon gas was bubbled, and stirred until the Te powder was completely dissolved to be yellow transparent. After the dissolution, the solution was allowed to cool to room temperature, to obtain a Te source liquid (0.3 M).

[Preparation of ZnTe Source Liquid]

The Te source liquid (0.3 M) was weighed so that the molar composition ratio $x_S$ of S of the colloidal quantum dot was 0.45 (the molar composition ratio $1-x_S$ of Te was 0.55). To the Te source liquid, 25 μL (0.25 mmol) of diethylzinc (DEZ) as the Zn source liquid was added, and TOP was added so that the total amount was 2 mL. The mixture was sufficiently mixed by a tube mixer, to change the color of the solution from yellow transparent to colorless transparent. This mixed solution obtained by mixing the Zn source liquid and the Te source liquid was used as a third mixed liquid.

[Preparation of S Source Liquid]

1-dodecanethiol was weighed as a S source liquid so that the molar composition ratio $x_S$ of S of the colloidal quantum dot was 0.45. To the S source liquid, 9.4 mL (20 mmol) of OLA as the capping agent was added, and ODE as a diluent was added so that the total amount was 20 mL. The mixture was sufficiently mixed by a tube mixer, to prepare a fourth mixed liquid in which the S source liquid, the capping agent, and the diluent were mixed.

[Procedure for Synthesis of $Zn(Te_{1-x}, S_x)$ Colloidal Quantum Dot]

While the fourth mixed liquid was stirred, the fourth mixed liquid was subjected to a deaeration treatment in vacuum "at 120°C for 30 minutes." The pressure of the mixture was then returned to atmospheric pressure using an argon gas, and the mixture was heated to 300°C with stirring while an argon gas was bubbled. It was confirmed that the temperature of the fourth mixed liquid was stable. After then, the third mixed liquid was rapidly injected into the fourth mixed liquid by a syringe. The reaction solution after the injection was held at a temperature of 290°C for 15 minutes with stirring, to grow a colloidal quantum dot. The colloidal quantum dot was allowed to cool to room temperature. The reaction solution was a transparent solution without cloud. Herein, conditions for adjustment of the average particle diameter to $6.0 \pm 0.1$ nm are that the temperature of the fourth mixed liquid is heated to 300°C, the growth temperature after injection of the third mixed liquid into the fourth mixed liquid is 290°C, and the growth time at this temperature is 15 minutes. When the temperature of the fourth mixed liquid, the growth temperature after injection of the third mixed liquid into the fourth mixed liquid, and the growth time at this temperature are adjusted, the particle diameter of the colloidal quantum dot can be adjusted. These conditions are shown in Table 4 below.

[Table 4]

|  | $x_S$ (Preparation) | Temperature of fourth mixed liquid [°C] | Growth temperature [°C] | Growth time [min] | Optical gap [eV] | Emission energy [eV] | Average particle diameter [nm] |
|---|---|---|---|---|---|---|---|
| Example 13 | 0.45 | 300 | 290 | 15 | 2.12 | 2.02 | 6.0 |
| Example 14 | 0.40 | 300 | 290 | 15 | 2.08 | 1.98 | 6.1 |
| Example 15 | 0.35 | 300 | 290 | 45 | 2.06 | 1.96 | 6.1 |
| Example 16 | 0.30 | 300 | 290 | 15 | 2.06 | 1.96 | 5.9 |
| Example 17 | 0.15 | 280 | 270 | 30 | 2.16 | 2.06 | 6.0 |
| Comparative Example 6 | 0.00 | 280 | 270 | 45 | 2.44 | 2.34 | 6.1 |
| Comparative Example 7 | 1.00 | 290 | 290 | 14 | 3.88 | 3.78 | 5.9 |

Extraction of the $Zn(Te_{1-x}, S_x)$ colloidal quantum dot obtained in Example 13, growth of ZnS shell using the obtained $Zn(Te_{1-x}, S_x)$ colloidal quantum dot as a core, and extraction of the $Zn(Te_{1-x}, S_x)$/ZnS core-shell colloidal quantum dot thus obtained were each performed in the same manner as in Example 1.

<Examples 14 to 17 and Comparative Example 6>

In Examples 14 to 17 and Comparative Example 6, the same Te source liquid, S source liquid, TOP, DEZ, and the like as those in Example 13 were used. In Examples 14 to 17 and Comparative Example 6, the Te source liquid, the S source liquid, TOP, DEZ, and the like were weighed so that the molar composition ratio $x_S$ of S of a colloidal quantum dot was as shown in Table 4 above, and the temperature of the fourth mixed liquid, the growth temperature after injection of the third mixed liquid into the fourth mixed liquid, and the growth time at this temperature were adjusted. Thus, the particle diameter of the colloidal quantum dot was adjusted to $6.0 \pm 0.1$ nm. A $Zn(Te_{1-x}, S_x)$/ZnS core-shell colloidal quantum dot was synthesized in the same manner as in Example 13 except for aforementioned points.

<Comparative Example 7>

[Synthesis of ZnS Colloidal Quantum Dot]

[Preparation of Source Solution]

18.3 mg (0.1 mmol) of zinc acetate anhydrous, 3.5 mL (10.91 mmol) of ODE, and 0.330 mL (1.00 mmol) of OLA were weighed in a 10-mL vial, and stirred by a shaker warmed to 60°C, and zinc acetate anhydrous was completely dissolved to prepare a colorless transparent Zn source liquid. 25.7 mg (0.8 mmol) of S powder and 2.0 ml (4.48 mmol) of TOP were weighed in another 10-mL vial so that the molar composition ratio $x_S$ of S of a colloidal quantum dot was 1.00. The S powder was completely dissolved in an ultrasonic cleaner, to prepare a colorless transparent S source liquid.

[Procedure for synthesis of ZnS Colloidal Quantum Dot]

In a 10-mL vial including the Zn source liquid, 1.5 mL of the S source liquid was placed, and the mixture was sufficiently stirred. The vial was immersed in an oil bath heated to 280°C, and held for 9 minutes while an argon gas was bubbled. The vial was then taken out from the oil bath, and allowed to cool to room temperature. The reaction solution was a light yellow transparent solution.

[Extraction of ZnS colloidal quantum dot from reaction solution]

Extraction of the ZnS colloidal quantum dot from the reaction solution was performed by the same procedure as that for the $Zn(Te_{1-x}, S_x)$ colloidal quantum dot.

The molar composition ratio $x_S$ of S of the colloidal quantum dot in Comparative Example 7, the temperature of the fourth mixed liquid, the growth temperature after injection of the third mixed liquid into the fourth mixed liquid, and the growth time at this temperature are shown in Table 4 above .

<Example 18>

The same Te source liquid, TOP, and DEZ as in Example 13 were each weighed so that the molar composition ratio $x_S$ of S of a colloidal quantum dot was 0.35, and sufficiently mixed in a 10-mL vial, to obtain a third mixed liquid. On the other hand, a S source liquid was weighed so that the molar composition ratio $x_S$ of S was 0.35. To the S source, OA and ODE were added to prepare a fourth mixed liquid. The fourth mixed liquid was heated to 310°C with stirring while an argon gas was bubbled. It was confirmed that the temperature of the fourth mixed liquid was stable. After then, the third mixed liquid was rapidly injected into the fourth mixed liquid by a syringe. The reaction solution after the injection was held at a temperature of 290°C for 10 minutes with stirring, to grow a colloidal quantum dot. The colloidal quantum dot was allowed to cool to room temperature. A $Zn(Te_{1-x}, S_x)/ZnS$ core-shell colloidal quantum dot was synthesized in the same manner as in Example 13 except for aforementioned points. The molar composition ratio $x_S$ of S of the colloidal quantum dot, the temperature of the fourth mixed liquid, the growth temperature after injection of the third mixed liquid into the fourth mixed liquid, and the growth time at this temperature are shown in Table 5 below.

[Table 5]

| | $X_S$ (Preparation) | Temperature of fourth mixed liquid [°C] | Growth temperature [°C] | Growth time [min] | Optical gap [eV] | Emission energy [eV] | Average particle diameter [nm] | Matching to extension of red region |
|---|---|---|---|---|---|---|---|---|
| Example 18 | 0.35 | 310 | 290 | 10 | 2.09 | 1.98 | 5.5 | Not matched |
| Example 19 | 0.35 | 310 | 290 | 20 | 2.06 | 1.96 | 6.0 | Matched |
| Example 20 | 0.35 | 310 | 290 | 30 | 2.05 | 1.95 | 6.3 | Not matched |
| Example 21 | 0.35 | 290 | 230 | 60 | 2.03 | 1.93 | 6.9 | Not matched |
| Example 22 | 0.35 | 290 | 270 | 60 | 2.01 | 1.91 | 7.5 | Not matched |
| Example 23 | 0.35 | 310 | 270 | 50 | 2.00 | 1.90 | 7.8 | Not matched |
| Example 24 | 0.35 | 300 | 300 | 60 | 1.98 | 1.88 | 8.3 | Not matched |

<Examples 19 to 24>

In Examples 19 to 24, a Te source liquid, TOP, DEZ, and the like were weighted so that the molar composition ratio $x_S$ of S of a colloidal quantum dot was as shown in Table 5 above, a S source liquid was weighed so as to have the molar composition ratio $x_S$ of S, and to the S source, OA and ODE were added to prepare a fourth mixed liquid. The temperature of the fourth mixed liquid, the growth temperature after injection of the third mixed liquid into the fourth mixed liquid, and the growth time at this temperature were adjusted. Thus, the particle diameter of the colloidal quantum dot was adjusted. A $Zn\ (Te_{1-x}, S_x)/ZnS$ core-shell colloidal quantum dot was synthesized in the same manner as in Example 18 except for aforementioned points.

<Comparative Example 8>

[Synthesis of InP/ZnS Colloidal Quantum Dot]

In synthesis of InP core colloidal quantum dot of Comparative Example 8, a predetermined amount of weighed P source liquid was rapidly injected into a heated In source liquid by a syringe, and maintained for 30 minutes to prepare an InP core colloidal quantum dot reaction solution, although in Comparative Example 3, immediately quenched to room temperature. The InP core colloidal quantum dot reaction solution was prepared in the same manner as in Comparative Example 3 except for maintenance for 30 minutes . Additionally, an InP/ZnS core-shell colloidal quantum dot was obtained.

<Comparative Example 9>

[Synthesis of $CuInS_2$-ZnS Alloy/ZnS Colloidal Quantum Dot]

In synthesis of $CuInS_2$-ZnS alloy core colloidal quantum dot of Comparative Example 9, while an argon gas was bubbled, the temperature was increased to 200°C, and a mixture was maintained for three minutes as it was to prepare a $CuInS_2$-ZnS alloy core colloidal quantum dot reaction solution, although in Comparative Example 4, a mixture was maintained for 60 seconds as it was. The $CuInS_2$-ZnS alloy core colloidal quantum dot reaction solution was prepared in the same manner as in Comparative Example 4 except for maintenance for 3 minutes. Additionally, a $CuInS_2$-ZnS alloy/ZnS core-shell colloidal quantum dot was obtained.

<Comparative Example 10>

[Synthesis of CdSe/ZnS Colloidal Quantum Dot]

In synthesis of CdSe-ZnS colloidal quantum dot of Comparative Example 10, a capping agent was added to a mixed liquid of a Cd source liquid and a Se source liquid, and mixed with stirring, and the mixture was immersed in an oil bath of 280°C. In Comparative Example 5, a heating reaction was performed for a predetermined time until particles were grown to a particle diameter in which green light was emitted. In Comparative Example 10, a heating reaction was performed for a predetermined time until particles were grown to particle diameter in which red light was emitted. A CdSe/ZnS core-shell colloidal quantum dot was obtained in the same manner as in Comparative Example 5 except for aforementioned points.

<Comparison Evaluation of $Zn\ (Te_{1-x}, Se_x)$ Colloidal Quantum Dot>

For the $Zn(Te_{1-x}, Se_x)$ colloidal quantum dots obtained in Examples 1 to 12 and Comparative Examples 1 to 5, (1) absorption and emission properties when the average particle diameter was set to a certain value of $4.0 \pm 0.1$ nm and the molar preparation ratio ($x_{Se}$) of Se was changed from 0.00 to 1.00, and (2) the average particle diameter of the colloidal quantum dots were examined by methods described below. The results are shown in Tables 2 and 3, and Table 6 below.

[Table 6]

|  | Type of colloidal quantum dot | Emission wavelength [nm] | Average particle diameter [nm] | Full width at half maximum [nm] (emission spectrum) | Stokes shift [meV] |
|---|---|---|---|---|---|
| Example 7 | $Zn\ (Te_{1-x}, Se_x)/ZnS$ | 553 | 5.3 | 24 | 100 |

(continued)

|  | Type of colloidal quantum dot | Emission wavelength [nm] | Average particle diameter [nm] | Full width at half maximum [nm] (emission spectrum) | Stokes shift [meV] |
|---|---|---|---|---|---|
| Comparative Example 3 | InP/ZnS | 565 | 0.9 | 42 | 167 |
| Comparative Example 4 | $CuInS_2$-ZnS/ZnS | 562 | 1.4 | 105 | 631 |
| Comparative Example 5 | CdSe/ZnS | 560 | 2.9 | 33 | 65 |

(1) Absorption and Emission Properties

The absorption and emission properties were each measured by a spectrometer (U4100) manufactured by Hitachi Ltd., and a fluorescence spectrometer (FP6500) manufactured by JASCO Corporation. Energy values [eV] at expression and emission peaks were determined by the following Expression (7) at a peak wavelength λ [nm]. Herein, the Planck's constant is $6.62607 \times 10^{-34}$ [Jsec], and c is a velocity of light in vacuum of $2.99792 \times 10^8$ [m/sec].

$$E= \text{Planck's constant} \times c/\lambda \quad (7)$$

Herein, the energy value at the absorption peak was an optical gap. The wavelength at the emission peak was an emission wavelength. The difference between the energy values at the absorption and emission peaks was a stokes shift. The width of emission profile at a height of half of the emission peak is a full width at half maximum.

(2) Average Particle Diameter of Colloidal Quantum Dot

In calculation of average particle diameter of the colloidal quantum dot, a powder x-ray diffraction measurement (XRD: X-ray diffraction) was used. In measurement, the colloidal quantum dot on a reflection-free quartz plate was irradiated with a Cu-Kα ray generated by an X-ray diffractometer (RINT2500, Rigaku Corporation) having a rotating cathode X-ray generation source and a curved monochromator at an X-ray accelerating voltage of 40 kV and an electric current of 375 mA (15 kW). From the full width at half maximum (FWHM) of a diffraction pattern obtained in accordance with XRD, the average particle diameter $d_{XRD}$ was calculated by the Scherrer equation represented by the following Equation (8). Herein, B is the full width at half maximum [rad] of the diffraction pattern, and θ is the diffraction angle [rad] thereof. As the Scherrer constant, 0.9 was used. The average particle diameter $d_{XRD}$ was determined by linear approximation in accordance with the least-squares method of cosθ of the diffraction pattern and plot of 0.9λ/B in each diffraction plane of (111) plane, (220) plane, and (311) plane.

$$d_{XRD}=0.9\lambda/B\cos\theta \quad (8)$$

As apparent from Table 2 above, when the average particle diameter is adjusted to $4.0 \pm 0.1$ nm and the molar preparation ratio ($x_{Se}$) of Se is adjusted to a range of 0<x<1, the emission energy of the $Zn(Te_{1-x}, Se_x)$ colloidal quantum dot can be controlled to a predetermined value within a range of green region of 2.15 to 2.45 eV. In particular, when the molar preparation ratio ($x_{Se}$) of Se is adjusted within a range of 0.25 to 0.40, the minimum value of emission energy of the $Zn(Te_{1-x}, Se_x)$ colloidal quantum dot exhibits about 2.3 eV.

Conditions for synthesis of colloidal quantum dot when the molar preparation ratio ($x_{Se}$) of Se of $Zn(Te_{1-x}, Se_x)$ is set to a constant value of 0.30 and the average particle diameter is adjusted are shown in Table 3 above.

As apparent from Table 3, when the molar preparation ratio ($x_{Se}$) of Se is adjusted to 0.30, the temperature of the second mixed liquid which is the mixed solution of OA and ODE, the growth temperature after injection of the first mixed liquid as the source solution into the second mixed liquid, and the growth time at this temperature are adjusted, and the average particle diameter is adjusted to 3.5 to 6.3 nm. In this case, the emission energy of the $Zn(Te_{1-x}, Se_x)$ colloidal quantum dot can be adjusted to a green region of 2.15 to 2.45 eV due to a quantum size effect. A green wavelength required for extension of color gamut is especially about 530 nm (2.33 to 2.34 eV). In Example 11 where the elongation is achieved, a case of achieving matching in "Matching to extension of green region" in Table 3 exhibits "Matched," and a case of not achieving matching exhibits "Not matched."

As apparent from Table 6, the average particle diameter of the colloidal quantum dot of Example 7 can be firstly increased as compared with InP/ZnS (Comparative Example 3) and three-element-compound semiconductor (Comparative Example 4) which are typical examples of Cd-free colloidal quantum dot capable of emitting green light as visible fluorescence. Therefore, the emission wavelength controllability is highly improved. Secondly, the edge of the full width at half maximum (FWHM) is highly improved, and thus a good chromaticity can be achieved as compared with the existing Cd-free colloidal quantum dot. Accordingly, extension of color gamut is expected. Thirdly, the stokes shift is largely reduced, and the energy loss is largely reduced. For extension of color gamut, the colloidal quantum dot of Example 7 exhibits the same properties as those of CdSe/ZnS (Comparative Example 5). Under the circumstances where the trend of replacement of Cd is rapidly accelerated, it is found that a colloidal quantum dot using CdSe/ZnS is considered to be a convincing candidate.

<Comparison Evaluation of Zn$(Te_{1-x}, S_x)$ Colloidal Quantum Dot>

For the Zn$(Te_{1-x}, S_x)$ colloidal quantum dots obtained in Examples 13 to 24 and Comparative Examples 6 and 7, (1) absorption and emission properties and (2) the average particle diameter of colloidal quantum dots were examined when the average particle diameter was set to a certain value of $6.0\pm0.1$ nm and the molar preparation ratio ($x_S$) of S was changed from 0.00 to 1.00. The results are shown in Tables 4 and 5 above.

[Table 7]

| | Type of colloidal quantum dot | Emission wavelength [nm] | Average particle diameter [nm] | Full width at half maximum [nm] (emission spectrum) | Stokes shift [meV] |
|---|---|---|---|---|---|
| Example 19 | Zn$(Te_{1-x}, S_x)$/ZnS | 633 | 6.0 | 28 | 100 |
| Comparative Example 8 | InP/ZnS | 629 | 3.0 | 48 | 200 |
| Comparative Example 9 | CuInS$_2$-ZnS/ZnS | 631 | 3.4 | 126 | 520 |
| Comparative Example 10 | CdSe/ZnS | 635 | 4.9 | 26 | 50 |

As apparent from Table 4, when the average particle diameter is adjusted to $6.0\pm0.1$ nm and the molar preparation ratio ($x_S$) of S is adjusted to a range of 0<x<1, the emission energy of the Zn$(Te_{1-x}, S_x)$ colloidal quantum dot can be controlled to a predetermined value within a range of red region of 1.80 to 2.10 eV. In particular, when the molar preparation ratio ($x_S$) of S is within a range of 0.30 to 0.35, the minimum value of emission energy of the Zn$(Te_{1-x}, S_x)$ colloidal quantum dot exhibits about 1.96 eV.

Conditions for synthesis of colloidal quantum dot when the molar preparation ratio ($x_S$) of S of Zn$(Te_{1-x}, S_x)$ is set to a constant value of 0.35 and the average particle diameter is adjusted are shown in Table 5 above.

As apparent from Table 5, when the molar preparation ratio ($x_S$) of S is adjusted to 0.35, the temperature of the fourth mixed liquid which is the mixed solution of OA and ODE, the growth temperature after injection of the third mixed liquid as the source solution into the fourth mixed liquid, and the growth time at this temperature are adjusted, whereby the average particle diameter is adjusted to 5.5 to 8.3 nm. In this case, the emission energy of the Zn$(Te_{1-x}, S_x)$ colloidal quantum dot can be adjusted to a red region of 1.80 to 2.10 eV due to a quantum size effect. Especially, red wavelength required for extension of color gamut is about 630 nm (1.96 to 1.97 eV). In Example 19 where the elongation is achieved, a case of achieving matching in "Matching to extension of red region" in Table 5 exhibits "Matched, " and a case of not achieving matching exhibits "Not matched."

As apparent from Table 7, firstly, the average particle diameter of the colloidal quantum dot can be increased as compared with InP/ZnS (Comparative Example 8) and three-element-compound semiconductor (Comparative Example 9) which are typical examples of Cd-free colloidal quantum dot capable of emitting red light as visible fluorescence. Therefore, the emission wavelength controllability is highly improved. Secondly, the edge of the full width at half maximum (FWHM) of the emission spectrum is highly improved, and thus a good chromaticity can be achieved as compared with the existing Cd-free colloidal quantum dot. Accordingly, extension of color gamut is expected. Thirdly, the stokes shift is largely reduced, and the energy loss is largely reduced. For extension of color gamut, the colloidal quantum dot of Example 19 exhibits the same characteristics as those of CdSe/ZnS (Comparative Example 10). Under the circumstances where a trend of replacing Cd is rapidly accelerated, it is found to be convincing candidate for a colloidal quantum dot as a replacement of CdSe/ZnS.

Industrial Applicability

The colloidal quantum dot capable of emitting visible fluorescence of the present invention can be used in fields of displays, illuminations, image for medical care, biosensors, LEDs, and lasers.

**Claims**

1. A Cd-free colloidal quantum dot which is a core particle that is coated with a shell made from a compound semiconductor and serves as a core for the shell, emits visible fluorescence upon irradiation with excited light having a wavelength of a near ultraviolet region or a blue region, is represented by a chemical formula: $A(B1_{1-x}, B2_x)$ (wherein $0<x<1$), has Zn as a Group-II element in the A site, Te as a Group-VI element in the B1 site, and Se or S as a Group-VI element in the B2 site, and has an average particle diameter of 1 nm or more and 10 nm or less.

2. The Cd-free colloidal quantum dot according to claim 1, wherein the B2 site is Se and the visible fluorescence is green light.

3. The Cd-free colloidal quantum dot according to claim 1, wherein the B2 site is S and the visible fluorescence is red light.

4. A method for producing a Cd-free colloidal quantum dot capable of emitting green light as visible fluorescence, comprising heating any one of a first mixed liquid prepared by mixing a Zn source liquid, a Te source liquid, and a Se source liquid, and a second mixed liquid prepared by mixing a capping agent with a diluent to a temperature of 200°C to 350°C, injecting into the heated liquid a predetermined amount of the other liquid under a nonoxidative atmosphere, adjusting the temperature of the liquid obtained by injecting the other liquid into the heated liquid to 200°C to 350°C, and holding the liquid for one minute to five hours.

5. A method for producing a Cd-free colloidal quantum dot capable of emitting red light as visible fluorescence, comprising heating any one of a third mixed liquid prepared by mixing a Zn source liquid with a Te source liquid, and a fourth mixed liquid prepared by mixing a S source liquid, a capping agent, and a diluent to a temperature of 200°C to 350°C, injecting into the heated liquid a predetermined amount of the other liquid under a nonoxidative atmosphere, adjusting the temperature of the liquid obtained by injecting the other liquid into the heated liquid to 200°C to 350°C, and holding the liquid for one minute to five hours.

[FIG. 1]

FIG.1

[FIG. 2]

FIG.2

[FIG. 3]

FIG.3

[FIG. 4]

FIG.4

## INTERNATIONAL SEARCH REPORT

| International application No. |
| --- |
| PCT/JP2018/000807 |

### A. CLASSIFICATION OF SUBJECT MATTER
Int. Cl. C09K11/88(2006.01)i, C09K11/08(2006.01)i, H01L33/50(2010.01)i

According to International Patent Classification (IPC) or to both national classification and IPC

### B. FIELDS SEARCHED

Minimum documentation searched (classification system followed by classification symbols)
Int. Cl. C09K11/88, C09K11/08, H01L33/50

Documentation searched other than minimum documentation to the extent that such documents are included in the fields searched
Published examined utility model applications of Japan 1922-1996
Published unexamined utility model applications of Japan 1971-2018
Registered utility model specifications of Japan 1996-2018
Published registered utility model applications of Japan 1994-2018

Electronic data base consulted during the international search (name of data base and, where practicable, search terms used)
JSTPlus/JMEDPlus/JST7580(JDreamIII) keywords: colloidal quantum dots and related terms, CAplus/REGISTRY (STN)

### C. DOCUMENTS CONSIDERED TO BE RELEVANT

| Category* | Citation of document, with indication, where appropriate, of the relevant passages | Relevant to claim No. |
| --- | --- | --- |
| X<br>Y | WO 2007/034877 A1 (NATIONAL INSTITUTE OF ADVANCED INDUSTRIAL SCIENCE AND TECHNOLOGY) 29 March 2007, claims, paragraphs [0052]-[0184], embodiment 5<br>& US 2009/0108235 A1 claims, paragraphs [0030]-[0166], embodiment 5 | 1<br>2-5 |
| X | JP 2006-291175 A (NATIONAL INSTITUTE OF ADVANCED INDUSTRIAL SCIENCE AND TECHNOLOGY) 26 October 2006, claims, paragraphs [0054], [0129]-[0130], embodiment 5 (Family: none) | 1 |
| Y | WO 2005/071764 A1 (HOYA CORP.) 04 August 2005, paragraphs [0050], [0089]-[0094]<br>& US 2008/0122341 A1 paragraphs [0075]-[0076], [0160]-[0171]<br>& CN 1910763 A | 2-5 |

☒ Further documents are listed in the continuation of Box C.  ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| | |

| Name and mailing address of the ISA/<br>    Japan Patent Office<br>    3-4-3, Kasumigaseki, Chiyoda-ku,<br>    Tokyo 100-8915, Japan | Authorized officer<br><br>Telephone No. |
| --- | --- |

Form PCT/ISA/210 (second sheet) (January 2015)

**INTERNATIONAL SEARCH REPORT**

International application No.

PCT/JP2018/000807

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2011-505432 A (EASTMAN KODAK CO.) 24 February 2011, claims, embodiments<br>& US 2010/0289003 A1 claims, embodiments<br>& WO 2009/058173 A1 & EP 2215187 A1 & CN 101835875 A | 1-5 |
| A | JP 2009-516182 A (SIGNALOMICS GMBH) 16 April 2009, claims, embodiments<br>& US 2009/0226371 A1 claims, embodiments<br>& WO 2007/057182 A2 & EP 1787659 A1 & CN 101360515 A | 1-5 |
| A | JP 2013-539798 A (YISSUM RESEARCH DEVELOPMENT COMPANY OF THE HEBREW UNIVERSITY OF JERUSALEM LTD.) 28 October 2013, claims, embodiments<br>& US 2013/0115455 A1 claims, embodiments<br>& WO 2012/035535 A1 & EP 2616522 A1 & CN 103154183 A | 1-5 |
| A | JP 2015-516467 A (KONINKLIJKE PHILIPS N.V.) 11 June 2015, claims, embodiments<br>& US 2014/0369024 A1 claims, embodiments<br>& WO 2013/114254 A2 & EP 2809710 A2 & CN 104105739 A | 1-5 |
| A | JP 2008-547235 A (SEOUL OPTO DEVICE CO., LTD.) 25 December 2008, claims, embodiments<br>& US 2008/0185604 A1 claims, embodiments<br>& WO 2007/007954 A1 | 1-5 |
| A | WO 2010/071137 A1 (METRO ELECTRIC CO., LTD.) 24 June 2010, claims, embodiments<br>& CN 102257508 A | 1-5 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6353 A
- JP 2017006353 A
- JP 248935 A
- JP 2017248935 A

**Non-patent literature cited in the description**

- **RYU et al.** *Chem. Mater.,* 2009, vol. 21 (4
- **NOSE et al.** *J. Phys.: Conf. Ser.,* 2009, vol. 165, 012028
- **KAMATA et al.** *J. Crystal Growth,* 1997, 170
- **NANDA et al.** *J. Appl. Phys.,* 2004, vol. 95 (9
- **PELLEGRINI et al.** *J. Appl. Phys.,* 2005, vol. 97, 073706